# EUROPÄISCHE PATENTSCHRIFT

(11) **EP 2 805 589 B1**
(45) Veröffentlichungstag und Bekanntmachung des Hinweises auf die Patenterteilung: **19.12.2018**
(21) Anmeldenummer: 13700613.6
(22) Anmeldetag: 09.01.2013
(51) Int. Cl.: H05K 7/02, H05K 7/20, H05K 5/00

(54) **ELEKTROGERÄT**
ELECTRIC DEVICE
APPAREIL ELECTRIQUE

(30) Priorität: 19.01.2012 DE 102012000907
(43) Veröffentlichungstag der Anmeldung: 26.11.2014
(73) Patentinhaber: Sew-Eurodrive GmbH & Co. KG, 76646 Bruchsal (DE)
(72) Erfinder: SCHMIDT, Josef, 76676 Graben-Neudorf (DE); SCHÖRNER, Martin, 76646 Bruchsal (DE)
(86) Internationale Anmeldenummer: PCT/EP2013/000036
(87) Internationale Veröffentlichungsnummer: WO 2013/107615

(56) Entgegenhaltungen:
- WO-A1-99/59225
- WO-A1-2012/104016
- DE-A1- 4 237 870

## Beschreibung

Die Erfindung betrifft ein Elektrogerät.

Es ist allgemein bekannt, dass Schaumstoff als Wärmesperre einsetzbar ist. Gehäuse von Elektrogeräten werden aus Metall oder Kunststoff hergestellt.

Aus der WO 2012/104016 A1 ist ein elektrisches Gerät bekannt, bei dem eine bestückte Leiterplatte zwischen zwei Kunststoffteilen angeordnet ist.

Aus der WO 99/59225 A1 ist ein Schaumstoffteil bekannt, das eine bestückte Leiterplatte umgibt.

Aus der DE 42 37 870 A1 ist ein Verfahren zur Herstellung eines elektronischen Steuergeräts für ein Kraftfahrzeug bekannt.

Der Erfindung liegt daher die Aufgabe zugrunde, ein Elektrogerät weiterzubilden, wobei eine möglichst einfache Herstellung ermöglicht sein soll.

Erfindungsgemäß wird die Aufgabe bei dem Elektrogerät nach den in Anspruch 1 angegebenen Merkmalen gelöst.

Wichtige Merkmale der Erfindung bei dem Elektrogerät,
aufweisend eine bestückte Leiterplatte und zumindest ein Schaumstoffteil
wobei das Schaumstoffteil die Leiterplatte zumindest teilweise gehäusebildend umgibt.

Von Vorteil ist dabei, dass die Wärme durch das Schaumteil abgeleitet wird. Das Schaumteil hat also nicht die Funktion einer Wärmesperre sondern die Funktion eines Wärme ableitenden Gehäuseteils. Das Stoßenergieabsorptionsvermögen des Schaumstoffes ist trotz seiner geringen Masse sehr hoch. Somit ist ein guter Schutz für die Leiterplatte erreichbar.

Somit fungiert der für die Wärme erzeugenden Bauelemente als Kühlanordnung wirksame Schaumstoff selbst auch als elektrischer Isolator, Berührschutz und Gehäuse.

Unter Schaumstoff werden hier aufgeschäumte Kunststoffe verstanden, die einen Volumenanteil der Gaseinschlüsse oder Gasbläschen von mehr als 50 % aufweisen. Beim Aufschäumen wird ein Grundmaterial durch Zugabe von Schaumzusätzen aufgeschäumt, wobei das Volumen des Stoffes mindestens sich verdoppelt. Vorzugsweise werden Kügelchen aus dem aufgeschäumtem Grundmaterial in einem Formwerkzeug mit heißem Wasserdampf beaufschlagt, so dass die Kügelchen verschweißen, also stoffschlüssig verbunden werden, und der gesamte Körper die vom Formwerkzeug vorgegebene Form erhält.

Bei einer vorteilhaften Ausgestaltung besteht der Schaumstoff aus einem aufgeschäumten Grundmaterial, welches Polypropylen und ein nicht-oxydisches Keramik-Material enthält,
insbesondere welches Siliciumcarbid, Bornitrid und/oder Borcarbid aufweist,
insbesondere mit einem Volumenanteil zwischen 3 % und 30 %. Von Vorteil ist dabei, dass ein Schaumstoff mit einfachen Mitteln wärmeleitend ausführbar ist.

Bei einer vorteilhaften Ausgestaltung sind ein oder mehrere Wärme erzeugende Bauelemente auf der Leiterplatte bestückt. Von Vorteil ist dabei, dass die Wärme durch das Gehäuse an die Umgebung abgeleitet wird, obwohl das Gehäuse aus Schaumstoff gefertigt ist.

Bei einer vorteilhaften Ausgestaltung sind die Schaumstoffteile miteinander formschlüssig verbunden, insbesondere schraubverbunden oder mittels Klipsverbindung. Von Vorteil ist dabei, dass eine einfache und sichere Verbindung ausgeführt ist.

Bei einer vorteilhaften Ausgestaltung ist das Elektrogerät mittels Schrauben an ein Montageteil, insbesondere metallisches Montageteil, anschraubbar, wobei die Schrauben Anpresskraftfluss in ein oder das Schaumstoffteil einleiten. Von Vorteil ist dabei, dass vom Elektrogerät erzeugte Wärme von dem Montageteil weiterleitbar ist.

Bei einer vorteilhaften Ausgestaltung ist ein Wärme erzeugendes Leistungsmodul, welches mit der Leiterplatte verbunden ist, auf einer von der Leiterplatte abgewandten Seite mit einem Kühlkörper, insbesondere mit einem Aluminium-Kühlkörper, verbunden, welcher ein Schaumstoffteil durchdringt, insbesondere und an seinem von dem Leistungsmodul abgewandten Seite in die Umgebung mündet, insbesondere in das Montageteil. Von Vorteil ist dabei, dass ein großer Wärmestrom über einen Kühlkörper an die Umgebung ableitbar ist. Die weiteren vom Elektrogerät erzeugten Wärmeströme werden über den Schaumstoff ableitbar.

Bei einer vorteilhaften Ausgestaltung ist mindestens ein Steckverbinderteil auf der Leiterplatte bestückt, welches aus einem oder dem Schaumstoffteil herausragt, insbesondere zur Verbindung mit einem Gegensteckverbinderteil. Von Vorteil ist dabei, dass elektrische Anschlüsse aus dem Schaumstoff herausragen und somit kontaktierbar sind. Das Steckverbinderteil ist bei der Bestückung der Leiterplatte automatisch bestückbar, wodurch die Herstellung einfach und kostengünstig ist.

Bei einer vorteilhaften Ausgestaltung ist im Schaumstoff ein metallisches Teil, insbesondere aus Aluminium oder Kupfer, angeordnet, welches aus dem Schaumstoff in die Umgebung herausragt und von der Leiterplatte und den darauf bestückten Bauelementen beabstandet ist. Von Vorteil ist dabei, dass eine verbesserte Wärmeableitung erreichbar ist. Denn die spezifische Wärmeleitfähigkeit des Schaumstoffes ist zwar besser als Luft, insbesondere mindestens zehnmal besser, allerdings ist sie schlechter als die von Kupfer und auch die von Aluminium.

Bei einer vorteilhaften Ausgestaltung ist das Leistungsmodul mit der Leiterplatte schraubverbunden,
insbesondere wobei eine Druckplatte auf der vom Leistungsmodul abgewandten Seite von einer Schraubverbindung gegen die Leiterplatte gedrückt wird und das Leistungsmodul gegen die Leiterplatte von der Schraubverbindung gedrückt wird. Von Vorteil ist dabei, dass ein geringer Druck im Kontaktbereich erzeugt wird. Dabei ist die Druckplatte aus Kunststoff oder ist zweistückig ausgeführt, wobei zur Leiterplatte hin ein elektrisch isolierendes Kunststoffteil angeordnet ist, welche von einer metallischen Platte angedrückt ist auf die Leiterplatte hin.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:
In der Figur 1 ist ein Querschnitt durch den schematischen Aufbau eines erfindungsgemäßen Ausführungsbeispiels gezeigt.
In der Figur 2 ist ein Querschnitt durch den schematischen Aufbau eines zweiten erfindungsgemäßen Ausführungsbeispiels gezeigt.
In der Figur 3 ist eine Schrägansicht auf das erste oder zweite Ausführungsbeispiel gezeigt.

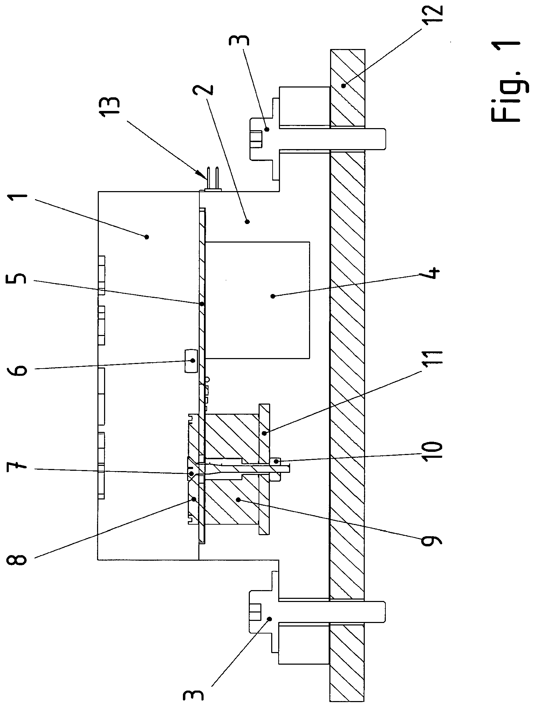

Wie in Figur 1 gezeigt, ist eine mit einem Wärme erzeugenden Bauelement 6 bestückte Leiterplatte 5 beidseitig von Schaumstoffteilen (1, 2) umgeben.

Hierzu ist ein erstes Schaumstoffteil 1 an die erste Seite der Leiterplatte 5, auf der auch das Bauelement 6 angeordnet ist, angesetzt.

Auf der anderen Seite der Leiterplatte 5 ist ein Leistungsmodul 9 bestückt, welches Leistungshalbleiter aufweist und somit auch eine hohe Wärmeleistung besitzt. Die Leiterplatte 5 ist samt Leistungsmodul 9 umgeben von dem zweiten Schaumstoffteil 2.

Die beiden Schaumstoffteile (1, 2) bilden gleichzeitig das Gehäuse. Sie umgeben also die bestückte Leiterplatte gehäusebildend.

Außerdem sind zumindest eines oder beide Schaumstoffteile (1, 2) auf wärmeleitfähigem Grundmaterial gefertigt.

Das Grundmaterial besteht aus Polypropylen, aus einem nichtoxydischen Keramik-Material, wie Siliciumcarbid, Bornitrid und/oder Borcarbid, und weiteren Zusätzen für Verbesserung des Flammschutzes und Verringerung des Kriechstroms, also Verbesserung der elektrischen Isolationsfestigkeit. Der Volumenanteil des Keramik-Materials, das als feines Pulver bei der Herstellung beigemischt wird, beträgt zwischen 3% und 30%. Somit ist eine hervorragende Wärmeleitfähigkeit erreichbar, obwohl das Grundmaterial aufgeschäumt wird und somit als Schaumstoffteil mit hohem Anteil an Gaseinschlüssen hergestellt ist. Zwar leiten die Gaseinschlüsse die Wärme sehr schlecht, jedoch sind die durch die Keramik-MaterialPartikel gebildeten Ketten in den aus dem Grundmaterial gebildeten Zellwänden derart als teilweise unterbrochen Ketten von der Wärmequelle zur Wärmesenke angeordnet, dass ein sehr geringer Wärmewiderstand durch das oder die Schaumstoffteile erreichbar ist.

Die Schaumstoffteile (1, 2) halten die bestückte Leiterplatte auch mechanisch und werden mittels schrauben 3, welche vorzugsweise einen verbreiterten Schraubenkopf aufweisen und/oder unter deren Schraubenkopf eine Unterlegscheibe angeordnet ist, gegen ein Montageteil 12, insbesondere Tisch oder Wand, gedrückt, indem die Schrauben 3 dort zumindest teilweise eingeschraubt sind.

Auf derselben Seite der Leiterplatte 5, auf welcher sich das Leistungsmodul 9 befeindet, ist auch ein Kondensator 4 vorgesehen, der als Zwischenkreiskondensators des von der bestückten Leiterplatte realisierten Umrichters fungiert.

Das Wärme erzeugende Bauelement 6 ist mit seinen Anschlusselementen lötverbunden mit Leiterbahnen der Leiterplatte.

Hingegen ist zum Verbinden des Leistungsmoduls 9 mit der Leiterplatte 5 eine Schraube 7 vorgesehen, deren Schraubenkopf auf eine Druckplatte 8 drückt, die - wie auch der Schraubenkopf - auf der von dem Leistungsmodul abgewandten Seite der Leiterplatte sich befindet.

Die Schraube 7 wird zur Erzeugung dieser Anpresskraft mit einer Mutter 10 verbunden, welche wiederum über eine Druckplatte auf das Leistungsmodul drückt, wobei die Mutter 10 und die Druckplatte 11 auf der von der Leiterplatte abgewandten Seite des Leistungsmoduls angeordnet sind.

Auf der Leiterplatte 5 ist auch ein Steckverbinderteil lötverbunden, dessen Kontakte aus dem Schaumstoffteil 2 herausragen, so dass von außen ein Gegensteckverbinderteil verbindbar ist. Auf diese Weise ist die Leiterplatte mit einem Datenbus verbindbar oder mittels einer sonstigen Datenschnittstelle zu einem weiteren Gerät verbindbar.

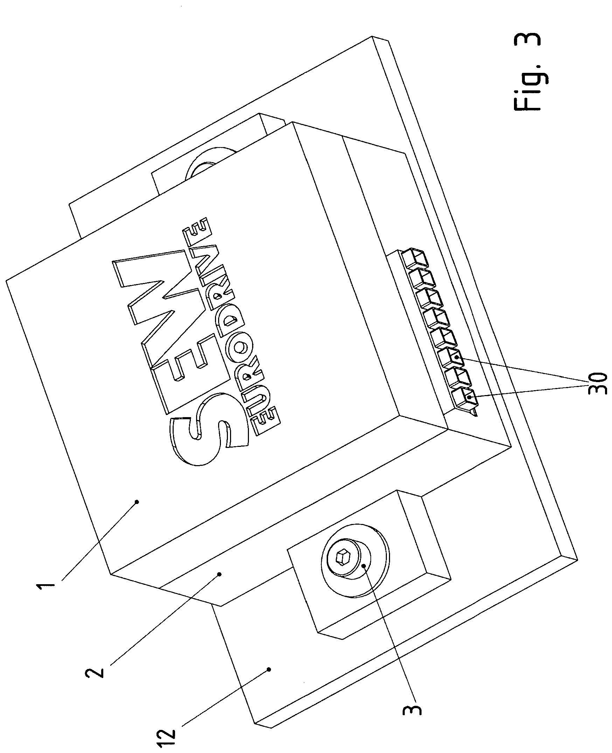

Wie in Figur 3 gezeigt, ist außerdem ein weiteres Steckverbinderteil 30 mit der Leiterplatte 5 lötverbindbar, so dass Versorgungsleitungen über ein Gegensteckverbinderteil, welches mit den ebenfalls aus dem Schaumstoffteil 2 herausragenden Kontakten des Steckverbinderteils 30 verbindbar ist.

Auf diese Weise ist also eine Leiterplatte bestückbar mit Bauelementen, einem Modul und Steckverbinderteilen, wonach die bestückte Leiterplatte von Schaumstoffteilen umgeben wird, insbesondere von entsprechend heißgeprägten Schaumstoffteilen.

Das so entstandene Elektrogerät ist transportfähig und anbaufähig an ein Montageteil 12.

Statt der Schaumstoffteile ist auch ein Umschäumen in einem Werkzeug ermöglicht. Beispielsweise wird hierzu die Leiterplatte in dem Werkzeug angeordnet, von kugelförmigen Grundmaterial-Teilchen umgeben und danach mit heißem Wasserdampf beaufschlagt, chemisch aufgeschäumt und/oder mit einem mehrkomponentigen Gemisch aufgeschäumt.

Auf diese Weise ist dann das Herstellen von einzelnen Schaumstoffteilen verzichtbar und das Gehäuse ist in einem einzigen Schritt herstellbar.

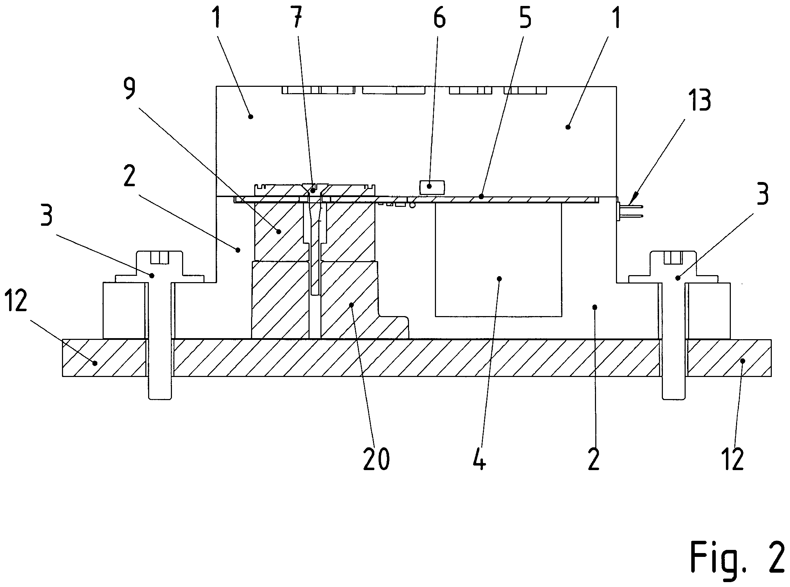

Wie in Figur 2 gezeigt, ist auch ein Kühlkörper 20 mit dem Leistungsmodul 5 verbindbar, so dass die Wärme des Leistungsmodul aus dem von den Schaumstoffteilen (1, 2) gebildeten Gehäuse über den direkten Kontakt vom Leistungsmodul 5 mit dem Kühlkörper 20 herausführbar ist an die Umgebung, insbesondere das Montageteil 12. Die Wärme, welche von dem Bauelement 6 und/oder von dem Kondensator 4 erzeugt wird, wird weiterhin über die wärmeleitenden Schaumstoffteile 1 beziehungsweise 2 an die Umgebung abgeführt.

Bei einem weiteren erfindungsgemäßen Ausführungsbeispiel werden statt der beiden Schaumstoffteile (1, 2) mehr oder weniger Schaumstoffteile verwendet zur Bildung der Gehäusefunktion, der Wärmeableitfunktion und der mechanischen Haltefunktion für die Leiterplatte samt Bestückung.

### Bezugszeichenliste

1 Schaumstoffteil, insbesondere Kunststoff-Schaumstoffteil
2 Schaumstoffteil
3 Schraube, insbesondere mit verbreitertem Schraubenkopf und/oder Unterlegscheibe
4 Kondensator
5 Leiterplatte
6 Wärme erzeugendes Bauelement
7 Schraube
8 Druckplatte
9 Leistungsmodul
10 Mutter
11 Druckplatte
12 Montageteil, insbesondere Tisch oder Wand
13 Steckverbinderteil
20 Kühlkörper
30 Steckverbinderteil

## Patentansprüche

1. Elektrogerät, aufweisend eine bestückte Leiterplatte (5) und zumindest ein Wärme leitender Schaumstoffteil (1, 2)
wobei das Schaumstoffteil (1, 2) die Leiterplatte (5) zumindest teilweise gehäusebildend umgibt,
wobei im Schaumstoff ein metallisches Teil, insbesondere aus Aluminium oder Kupfer, angeordnet ist, welches aus dem Schaumstoff in die Umgebung herausragt um die Wärmeableitung zu verbessern und das von der Leiterplatte (5) und den darauf bestückten Bauelementen (6) beabstandet ist.

2. Elektrogerät nach Anspruch 1,
**dadurch gekennzeichnet, dass**
der Schaumstoff aus einem aufgeschäumten Grundmaterial besteht, welches Polypropylen und ein nicht-oxydisches Keramik-Material enthält,
insbesondere welches Siliciumcarbid, Bornitrid und/oder Borcarbid aufweist,
insbesondere mit einem Volumenanteil zwischen 3 % und 30 %.

3. Elektrogerät nach mindestens einem der vorangegangenen Ansprüche,
**dadurch gekennzeichnet, dass**
ein oder mehrere Wärme erzeugende Bauelemente (6) auf der Leiterplatte (5) bestückt sind.

4. Elektrogerät nach mindestens einem der vorangegangenen Ansprüche,
**dadurch gekennzeichnet, dass**
die Schaumstoffteile (1, 2) miteinander formschlüssig verbunden sind, insbesondere schraubverbunden oder mittels Klipsverbindung.

5. Elektrogerät nach mindestens einem der vorangegangenen Ansprüche,
**dadurch gekennzeichnet, dass**
das Elektrogerät mittels Schrauben (3, 7) an ein Montageteil (12), insbesondere metallisches Montageteil (12), anschraubbar ist, wobei die Schrauben (3, 7) Anpresskraftfluss in ein oder das Schaumstoffteil (1, 2) einleiten.

6. Elektrogerät nach mindestens einem der vorangegangenen Ansprüche,
**dadurch gekennzeichnet, dass**
ein Wärme erzeugendes Leistungsmodul, welches mit der Leiterplatte (5) verbunden ist, auf einer von der Leiterplatte (5) abgewandten Seite mit einem Kühlkörper (20), insbesondere mit einem Aluminium-Kühlkörper (20), verbunden ist, welcher ein Schaumstoffteil (1, 2) durchdringt, insbesondere und an seinem von dem Leistungsmodul abgewandten Seite in die Umgebung mündet, insbesondere in das Montageteil (12).

7. Elektrogerät nach mindestens einem der vorangegangenen Ansprüche,
**dadurch gekennzeichnet, dass**
mindestens ein Steckverbinderteil (13, 30) auf der Leiterplatte (5) bestückt ist, welches aus einem oder dem Schaumstoffteil (1, 2) herausragt, insbesondere zur Verbindung mit einem Gegensteckverbinderteil.

8. Elektrogerät nach mindestens einem der vorangegangenen Ansprüche,
**dadurch gekennzeichnet, dass**
das Leistungsmodul mit der Leiterplatte (5) schraubverbunden ist,
insbesondere wobei eine Druckplatte (8, 11) auf der vom Leistungsmodul abgewandten Seite von einer Schraubverbindung gegen die Leiterplatte (5) gedrückt wird und das Leistungsmodul gegen die Leiterplatte (5) von der Schraubverbindung gedrückt wird.

## Claims

1. An electrical device,
having a populated printed circuit board (5) and at least one heat-conducting foam material part (1, 2)
wherein the foam material part (1, 2) surrounds the printed circuit board (5) at least partially in housing-forming manner,
wherein a metallic part, in particular made of aluminium or copper, is arranged in the foam material, which part protrudes out of the foam material into the surroundings in order to improve the dissipation of heat and which is spaced apart from the printed circuit board (5) and the components (6) fitted thereon.

2. An electrical device according to Claim 1,
**characterised in that**
the foam material consists of a foamed base material which contains polypropylene and a non-oxidic ceramic material,
in particular which has silicon carbide, boron nitride and/or boron carbide,
in particular with a volume percent of between 3% and 30%.

3. An electrical device according to at least one of the preceding claims, **characterised in that**
one or more heat-generating components (6) are fitted on the printed circuit board (5).

4. An electrical device according to at least one of the preceding claims, **characterised in that**
the foam material parts (1, 2) are connected together in positive manner, in particular screw-connected or by means of a clip connection.

5. An electrical device according to at least one of the preceding claims, **characterised in that**
the electrical device can be screwed by means of screws (3, 7) onto a mounting part (12), in particular metallic mounting part (12), the screws (3, 7) introducing a flow of pressure force into a or the foam material part (1, 2).

6. An electrical device according to at least one of the preceding claims, **characterised in that**
a heat-generating power module which is connected to the printed circuit board (5) is connected on a side remote from the printed circuit board (5) to a cooling body (20), in particular to an aluminium cooling body (20), which penetrates a foam material part (1, 2), in particular and opens on its side remote from the power module into the surroundings, in particular into the mounting part (12).

7. An electrical device according to at least one of the preceding claims, **characterised in that**
at least one plug-in connector part (13, 30) is fitted on the printed circuit board (5), which part protrudes out of a or the foam material part (1, 2), in particular for connection to a mating connector part.

8. An electrical device according to at least one of the preceding claims, **characterised in that**
the power module is screw-connected to the printed circuit board (5),
in particular wherein a pressure plate (8, 11) is pressed on the side remote from the power module against the printed circuit board (5) by a screw connection and the power module is pressed against the printed circuit board (5) by the screw connection.

## Revendications

1. Appareil électrique,
présentant une carte à circuits imprimés (5) munie de composants et au moins un élément thermo-conducteur (1,2) en matière alvéolaire,
sachant que l'élément (1, 2) en matière alvéolaire entoure la carte à circuits imprimés (5) au moins partiellement pour former un boîtier,
sachant qu'un élément métallique, en particulier en aluminium ou en cuivre, est disposé dans le matériau alvéolaire, élément qui dépasse hors du matériau alvéolaire dans l'environnement afin d'améliorer la dissipation de chaleur, et qui est distant de la carte à circuits imprimés (5) et des composants (6) installés sur celle-ci.

2. Appareil électrique selon la revendication 1, **caractérisé en ce que** la matière alvéolaire est constituée d'un matériau de base moussé qui contient du polypropylène et un matériau céramique non oxydique,
en particulier qui présente du carbure de silicium, du nitrure de bore et/ou du carbure de bore,
en particulier avec une part volumique comprise entre 3 % et 30 %.

3. Appareil électrique selon au moins une des revendications précédentes, **caractérisé en ce qu'**un ou plusieurs composants (6) produisant de la chaleur sont installés sur la carte à circuits imprimés (5).

4. Appareil électrique selon au moins une des revendications précédentes, **caractérisé en ce que** les éléments (1, 2) en matière alvéolaire sont mutuellement reliés en engagement positif, en particulier par vissage ou au moyen d'une liaison par clips.

5. Appareil électrique selon au moins une des revendications précédentes, **caractérisé en ce que** l'appareil électrique peut être vissé au moyen de vis (3, 7) sur un élément de montage (12), en particulier un élément de montage métallique (12), sachant que les vis (3, 7) introduisent un flux de force de pression dans un élément (1, 2) ou l'élément (1, 2) en matière alvéolaire.

6. Appareil électrique selon au moins une des revendications précédentes, **caractérisé en ce qu'**un module de puissance produisant de la chaleur, qui est relié à la carte à circuits imprimés (5), est relié sur un côté éloigné de la carte à circuits imprimés (5) à un corps de refroidissement (20), en particulier un corps de refroidissement (20) en aluminium, corps qui traverse un élément (1, 2) en matière alvéolaire et qui en particulier, sur son côté éloigné du module de puissance, débouche dans l'environnement, en particulier dans l'élément de montage (12).

7. Appareil électrique selon au moins une des revendications précédentes, **caractérisé en ce qu'**au moins un élément connecteur (13, 30) est installé sur la carte à circuits imprimés (5), élément qui dépasse hors d'un élément (1, 2) ou de l'élément (1, 2) en matière alvéolaire, en particulier pour la liaison avec un élément connecteur complémentaire.

8. Appareil électrique selon au moins une des revendications précédentes, **caractérisé en ce que** le module de puissance est relié par vissage à la carte à circuits imprimés (5),
sachant en particulier qu'une plaque de pression (8, 11) est, sur le côté éloigné du module de puissance, pressée par une liaison par vis contre la carte à circuits imprimés (5), et que le module de puissance est pressé contre la carte à circuits imprimés (5) par la liaison par vis.
